Europäisches Patentamt

European Patent Office

Office européen des brevets

(11) Publication number: **0 122 663**
A2

## (12) EUROPEAN PATENT APPLICATION

(21) Application number: **84200475.6**

(22) Date of filing: **05.04.84**

(51) Int. Cl.³: **H 03 G 5/18**
**H 04 R 3/04**

(30) Priority: **08.04.83 IL 68336**
**13.06.83 US 503830**

(43) Date of publication of application:
**24.10.84 Bulletin 84/43**

(84) Designated Contracting States:
**DE FR GB IT NL**

(71) Applicant: **Freadman, Tommyca**
**No. 28 Keren Hayesod Street**
**Ramat-Hasharon(IL)**

(72) Inventor: **Freadman, Tommyca**
**No. 28 Keren Hayesod Street**
**Ramat-Hasharon(IL)**

(74) Representative: **Noz, Franciscus Xaverius, Ir. et al,**
**Boschdijk 155 P.O. Box 645**
**NL-5600 AP Eindhoven(NL)**

(54) Method and system for improving speaker performance.

(57) In order to compensate for excursion limitations in a speaker system, a control circuit is provided for dynamically modifying the frequency response of the audio input signal prior to being applied to a power amplifier which drives the speaker. The control circuitry includes a frequency divider for dividing the audio signal into high frequency and low frequency ranges, dc converters for providing dc control signals as a function of the amplitude of the high frequency and low frequency signals, an equalizer for receiving the audio input signal, and high frequency and low frequency shaper circuits which are controlled as a function of the dc control signals and operates to modify the frequency response of the equalizer. In a bi-amplified system, a separate control circuit is used for each speaker in the system in order to independently control the motion of each speaker. The use of the control circuitry of the present invention results in increased bandwidth, reduced distortion and increased maximum output level of the speaker system.

EP 0 122 663 A2

FIG. 1

- 1 -

METHOD AND SYSTEM FOR IMPROVING
SPEAKER PERFORMANCE

BACKGROUND OF THE INVENTION

      1.  Field of the Invention

This invention relates to powered speaker systems and more particularly, to a powered speaker system having reduced distortion, increased output capability and increased bandwidth.

      2.  Description of the Prior Art

Speakers which are mounted in free air conditions, such as speakers in motor vehicles and in infinity baffle arrangements, suffer generally from high intermodulation distortion, low sound pressure output capability and poor efficiency.

It is known that when a speaker driver is optimized for a particular output level (e.g., 100 db with a low distortion input) an input signal corresponding to an increased sound pressure level (e.g., 106 db, which is approximately the minimum required dynamic headroom for high fidelity sound reproduction) may drive the speaker into high distortion. In extreme instances, the voice coil of the speaker may jump out of its gap due to instability of the speaker cone movement. This may result in an intermodulation distortion of up to 20%-30%. Previously, the problem has been avoided by using stiffer suspension spiders and cone edges in order to control the motion of the speaker diaphragm. However, these means dramatically reduce the efficiency of the speaker, and moreover, magnify the lack of efficiency at low output levels.

For medium power amplifiers which are designed to drive speakers to high sound pressure levels (s.p.l.) the optimization of the speaker's sensitivity (which is a function of suspension and magnetic flux) is almost impossible. The s.p.l. in this case is not linear relative to the power multiplication, i.e., a 3 db increase in s.p.l. for each doubling of the power input.

The specifications and data quoted by manufacturers for standard speakers are insufficient to judge whether the quality of the speaker is good or bad. These specifications usually show that at different power and frequencies levels, the speakers do not operate at a fixed efficiency rate but are constantly changing. Even speakers with the same frequency response characteristics may have different efficiency characteristics. Furthermore, a multi-speaker arrangements with multi-signal inputs is prone to intermodulation distortion and magnification of the non-linearity problems.

Prior art systems generally have not solved the problem of non-linearity of efficiency at different output levels. This problem is easily detected when speakers are played at different acoustic sound pressure levels, demonstrating that the information reproduced by the speakers is not constant with respect to frequency content. At low output levels, a large low frequency boost is needed due to the fact that the human ear is less sensitive to extreme low (and high) frequency sounds at lower s.p.l., e.g., 60 db, than at high levels, e.g., 100 db. At high s.p.l., the ear/brain system perceives all frequencies nearly equal in loudness.

If the speaker is considered as a radiator of sound waves, the purpose of which is to deliver the full sound spectrum to the listener with an accurate frequency balance, it becomes apparent that a linear driver (amplifier) will not achieve this performance. In other words, the driver must be modified and so designed as to complete and compensate for the lack of performance of the speaker and the varying frequency sensitivity of the ear as a function of volume.

Alteration of the frequency response to compensate for non-linear dynamic limitations of speakers is usually effected by using conventional equalizers which boost certain frequencies by the same amount regardless of the setting of the output level of the sound. Thus, if a 10 db boost is necessary at 60 db, the equalizer will also boost the level at 100 db. In addition, although the amplifier may be putting out a power level corresponding to a 110 db output, the speaker may only be outputting only 103 db s.p.l., and half the acoustic output would be distorted because the speaker is beyond its linear limit. Finally, when the coil jumps out of the gap, an avalanche affect occurs in which the coil leaves the area of flux density, thus reducing the back electromagnetic field generated by the moving coil and increasing the current through the coil. The increased current causes an increased force in the direction away from the gap, with the result being very high distortion and bottoming sound from the speaker.

SUMMARY OF THE INVENTION

The fundamental approach of the present invention is that optimum performance of the speaker system is achieved by designing the amplifier and speaker as an integral unit. The ampifier includes means for providing a dynamically changing amount of pre-emphasis to the input signal in order to alter the frequency response of the drive signal to the speaker so as to compensate for output limitations of the speaker and varying sensitivity of the human ear. Integrally combining the electronic amplification circuit with the speaker results in improved characteristics which enable an increase of the acoustic pressure, a widening of the frequency response curve and a decrease in distortion. The degree of pre-emphasis and thus the frequency response of signal to the speaker is changed dynamically as a function of the level of the input signal and can be designed to take into account the mechanical limitations of the speaker-amplifier systems.

It is an object of the present invention to provide a dynamic electronic circuit, controlled by the input signal, which will control the movement of a speaker coil in the magnetic field, under optimal conditions and at different sound pressure levels, thus resulting in controlled movement of the speaker diaphragm.

It is a further object of the present invention to provide a sound radiator which will increase the maximum acoustic output, will widen the frequency response curve, and will almost eliminate distortion by predetermining the maximum movement of the speaker diaphragm. It is still a further object of the present invention to provide an improved sound radiator unit that is simple in construction and is inexpensive to manufacture.

The invention is directed to a method of controlling the performance of a speaker in a self-powered speaker system, characterized in that the audio signal is dynamically modified by an electronic control circuit before reaching the power amplifier which drives the speaker coil.

BRIEF DESCRIPTION OF THE DRAWINGS

The invention is illustrated, by way of example only, in the accompanying drawings in which:

FIGURE 1 is a vertical half-sectional view of the integrated amplifier and speaker sound radiator unit.

FIGURE 2 is a block diagram of the speaker/amplifier system of the present invention.

FIGURE 3 a schematic diagram showing further details of the components of FIGURE 2.

FIGURE 4 is a block diagram of a bi-amplified version of the present invention.

DESCRIPTION OF THE PREFERRED EMBODIMENT

The following description is of the best presently contemplated mode of carrying out the invention. This description is made for the purpose of illustrating the general principles of the invention and is not to be taken in a limiting sense. The scope of the invention is best determined by the appended claims.

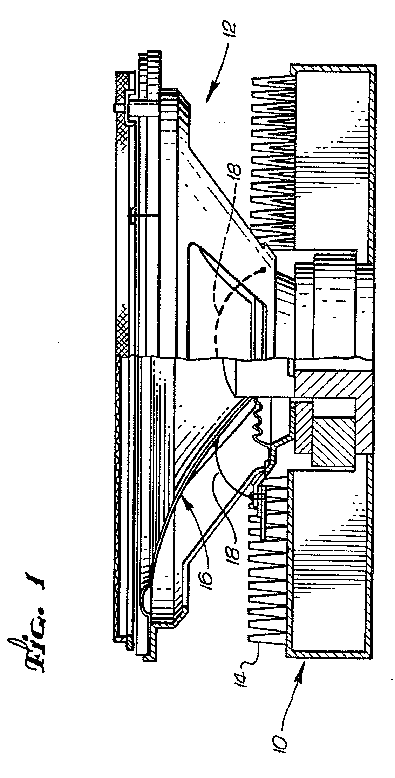

Referring to FIGURE 1, an electronic driver system 10 comprised of a power amplifier and the speaker control circuitry of the present invention is attached to the rear portion of a coaxial speaker unit 12. (Optionally, the control circuitry can be physically separate from the power amplifier and speaker.) The driver includes a heat sink 14 located between the cone diaphragm 16 and the driver, thus having the advantage that air waves produced by the movement by the speaker diaphragm will aid in the cooling of the driver system. Connections 18 are provided between the driver and the two speakers for high and low frequency ranges.

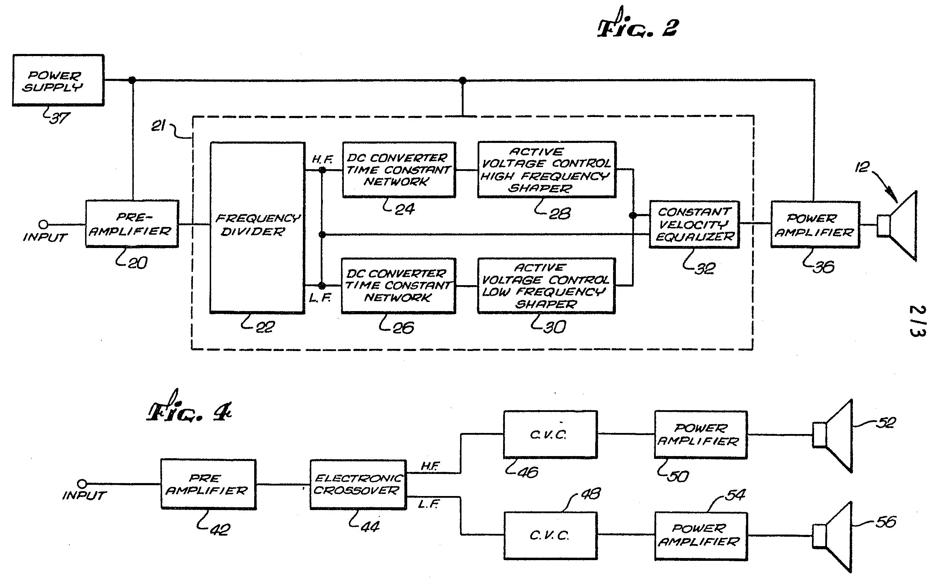

Referring now to FIGURE 2, the driver 10 includes a pre-amplifier 20 which receives an input signal and applies it to a "constant velocity control" circuit, or CVC 21. The CVC includes a frequency divider 22 which divides the input signal into high and low frequency ranges. High frequency signals from the frequency divider are applied to a first DC converter/time constant network 24, and low frequency signals are applied to a second DC converter/time constant network 26, both of which provide a DC output signal which is a function of the magnitude of the input signal. These DC signals are used to control high frequency and the low frequency active voltage control shaper circuits 28 and 30. The outputs of the shaper circuits 28 and 30 are fed to a constant velocity equalizer 32. The equalizer receives the recombined audio input signal from the frequency divider 22 and alters its frequency response as a function of the output of the frequency shapers 28 and 30. The output of the equalizer drives a power amplifier 36 which in turn drives the speaker 12. A power supply 37 provides a supply voltage to the pre-amplifier 20, CVC 21 and power amplifier 36.

The frequency response of the equalizer 32 is thus controlled by the outputs of the high frequency and low frequency shapers 28 and 30, respectively, which in turn are controlled by DC voltages proportional to the magnitude of the audio input signal. At low input signals, the shaper circuits have the greatest effect and cause the equalizer to boost the bass and treble frequencies. As the input signal increases, the boost decreases and eventually the low frequency cutoff is moved upward. Since maximum speaker cone excursion occurs at low frequencies, the shifting of the cutoff frequencies upward enables the speaker to provide a higher overall output level without exceeding its maximum excursion capabilities. The system thus provides dynamic equalization to the speaker as a function of the magnitude of the input signal. The constant velocity equalizer controls the motion of the speaker diaphragm regardless of its mechanical flexibility thereby to prevent the voice coil of the speaker from jumping out of the region of optimal magnetic flux. This significantly improves the efficiency of the speaker and enables it to reproduce undistorted waveforms at high acoustic presssure levels. The control circuitry 10 and speaker system 12 are an integrated system in which the power and velocity calculations which vary with the magnitude of the input signal are determined according to the mechanical charcteristics and structural limitations of the speaker and of the coil movement within the magnetic field.

The high frequency operation which is controlled by the converter 24 and frequency shaper 28 is provided not because of the speaker cone motion considerations but rather to maintain a balance in the overall sound reproduction of the speaker system. Since the low frequency response is controlled by the converter 26 and shaper 30 and in conjunction with the equalizer 32, an imbalance between high and low frequencies in reproduced signal might occur. Since the low frequency response is controlled, the attack characteristics of the high frequency spectrum should also be controlled. The converter 24 and high frequency shaper 28 operate such that when the high frequency portion of the input signal reaches a level corresponding to a sound pressure level higher than about 80 db at 4 KHz, the system enters in dynamic control of the high frequency range. This prevents the high frequencies from masking the low frequencies at high output levels. The object of the high frequency control portion of the system is not to control movement of the speaker coil, since in the high frequency range the over-excursion of the diaphragm is not critical, but rather to obtain optimal balance between high and low frequency ranges.

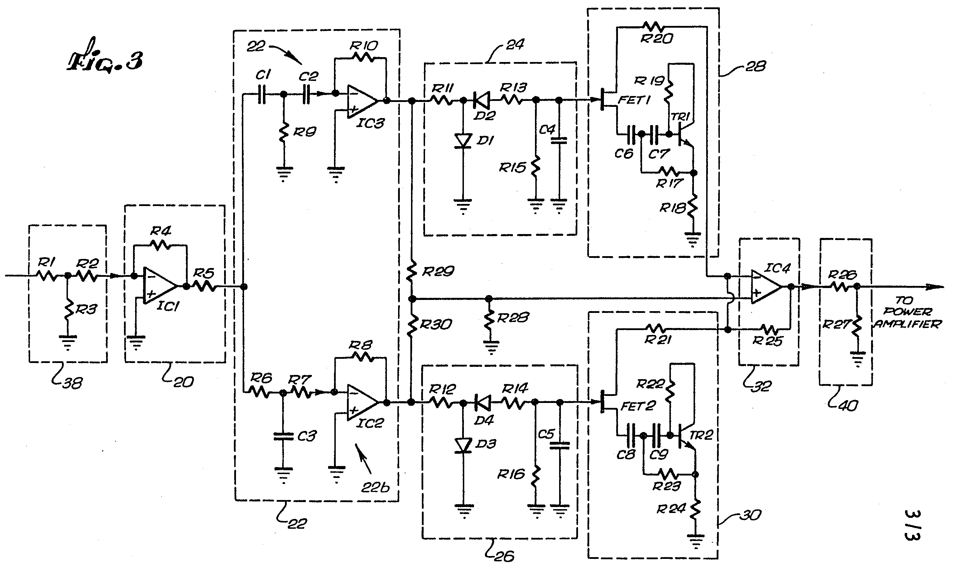

Referring now to FIGURE 3, a more detailed circuit diagram of the present invention is shown. The input signal is provided to a pad 38 which includes resistors R1, R2 and R3. The signal from the pad is fed to the pre-amplifier 20 which includes IC1 and resisitors R4 and R5. The output of the pre-amplifier is provided to the frequency divider 22 which includes a high pass network 22a and low pass network 22b. The high pass network includes capacitors C1 and C2, resistors R9 and R10 and IC3. The low pass network includes capacitors C3, resistors R6, R7 and R8 and IC2.

The outputs of IC2 and IC3 are connected to mixing resistors R29 and R30, the common connection of which is coupled to input of IC 4 in the constant velocity equalizer 32. The outputs of IC2 and IC3 are also coupled to the DC converter/time constant networks 24 and 26. The network 24 includes an isolating resistor R11 and a full wave rectifier including diodes D1 and D2. The DC voltage from D2, which is a negative voltage, passes through R13 into an RC arrangement in which C4 is the charging capacitor and R15 the discharging resistor. The voltage on C4 is a DC voltage proportional to the magnitude of the high frequency portion of the input signal and is used to control the high frequency shaper 28.

The DC converter 26 includes resistors R12, R14 and R16, diodes D3 and D4 and capacitor C5 and operates identically to the converter 24.

The speed of response of the system is determined by R15 and C4 in the converter 24 and R16 and C5 in the converter 26. The attack and the decay times of C4 and C5 determine the response velocity of the system.

The output of the converter 24 is the control input to the high frequency shaper 28 and specifically FET 1 in the shaper 28. The shaper operates as an active conductor which creates a resonance as a function of the value of the input signal to the FET 1. The shaper includes resistors R17-R20, capacitors C6 and C7 and transistor TR1. The FET 1 operates a voltage controlled resistor whose resistance varies depending upon the value of the DC signal output of the converter 24. The shaper provides a DC output signal through resistor R20 which is coupled to the inverting input of IC4 of the constant velocity equalizer 32. The transistor TR1 acts as a resonator whose resonance point is varied as a function of the drive on the FET 1.

The low frequency shaper 30 operates in a fashion similar to the high frequency shaper, with the FET 2 changing its resistance as a function of the input signal from the DC converter 26. The shaper includes resistors R21-R24, capacitors C8 and C9 and transistor TR2. The resonance point of the transistor TR2 varies as a function of the drive of FET 2.

When the voltage input to FET 1 and FET 2 is low, i.e., the input signal is at a low amplitude, the resonators have a maximum influence on the constant velocity equalizer 32 (comprised of IC4 and feedback resistor R25) since the resistances of the FET's is low and the resonators can influence the feedback through resistor R25. When the input voltage to the frequency shapers increases, the resistance of FET 1 and FET 2 increases, thereby reducing the influence of the resonators on the constant velocity equalizer 32. Thus, the frequency response of the output signal of the equalizer 32 is dynamically changed and is dependant on the level of the input signal.

The constant velocity equalizer 32 thus provides an output signal whose frequency response varies as a function of the magnitude of the input signal. A portion of the input signal is provided directly to the IC4, whereas the remainder of the input signal is utilized to generate control signals for modifying the response of the IC4 and resistor R25 combination. The output of IC4 is coupled to an output pad 40 which includes resisitors R26 and R27. The output signal is in turn coupled to the power amplifier.

The operation of the frequency shapers is such that at low volumes, the resonators operate to boost high and low frequencies in the output of the constant velocity equalizer. As the input signals increases the boost is removed and low frequency response is reduced in order to limit the maximum excursion of the speaker diaphragm.

Referring to FIGURE 4, the present invention can employ a pair of CVC's in a bi-amplified configuration. In such a system, the input signal is provided to a pre-amplifier 42, the output of which is delivered to an electronic crossover 44 which divides the signal into high frequency and low frequency portions. These signals are coupled to a first CVC 46 and second CVC 48, respectively. Each CVC is the same as the CVC 21 shown in FIGURE 3 (i.e., a frequency divider, a pair of DC converters, high and low frequency shapers and a constant velocity equalizer is included in each CVC 46 and 48). The output of the CVC 46 is coupled to a power amplifier 50 which drives a high frequency speaker 52 and the output of the CVC 48 is coupled to a power amplifier 54 which drives a low frequency speaker 56. The components in the CVC's 46 and 48 are chosen to match the characteristics of the speakers 52 and 56 respectively. Thus, the low frequency shaper of the CVC 46 operates to prevent the speaker 52 from exceeding its maximum excursion capability and the low frequency shaper of the CVC 48 operates to prevent the speaker 56 from exceeding its maximum excursion capability. In this fashion, a multispeaker system may be controlled to compensate for the characteristics of each speaker in
the system.

The figures used in the claims are only meant to explain more
clearly the intention of the invention and are not supposed to be any
restriction concerning the interpretation of the invention.

- 1 -

CLAIMS

1. A method of controlling the operation of a speaker in a self-powered speaker system comprising the steps of:

generating a control signal as a function of the magnitude of an audio input signal;

applying the control signal to an equalizer network to vary the frequency response of the equilizer network;

passing the audio input signal through the equalizer network thereby to dynamically modify the frequency response of the audio input signal as a function of its magnitude; and

applying the modified signal to a power amplifier which drives a speaker system.

2. A powered speaker system comprising:

a speaker;

a power amplifier for driving the speaker; and

control circuitry for providing an audio drive signal to the power amplifier, said control circuitry receiving an audio input signal and including means for dynamically modifying the frequency response of the input signal as a function of the magnitude of the input signal, wherein the modified input signal is the drive signal to the power amplifier.

3. A powered speaker system according to claim 2 wherein the control circuitry includes a converter network for generating a dc control signal as a function of the magnitude of the audio input signal and an equalization network whose frequency response is controlled by the dc control signal, wherein the audio input signal is passed through the equalization network prior to being applied to the power amplifier.

4. A powered speaker system according to claim 3 wherein the control circuitry includes a frequency divider for dividing the audio input signal into high and low frequency ranges and the converter network includes separate converters for generating first and second dc control signals which are applied to the equalization network to separately control the high and low frequency response of the equalization network.

5. A bi-amplified self-powered speaker system comprising:

    a first speaker;

    a first power amplifier for driving the first speaker;

    a second speaker;

    a second power amplifier for driving the second speaker;

    control circuitry for receiving an audio input signal which has been divided into high and low frequency ranges, said control circuitry including a first equalization network for dynamically modifying the frequency response of the high frequency range of the audio input signal and applying it to the first power amplifier, said control circuitry further including a second equalization network for dynamically modifying the frequency response of the low frequency range of the audio input signal and applying it to the second power amplifier.

6. A speaker system as in claim 5 wherein the first equalization network includes means for separately modifying the frequency response of relatively high and low frequency portions of the high frequency range of the audio input signal and the second equalization network includes means for separately modifying the frequency response of relatively high and low frequency portions of low frequency range of the audio input signal.

7. A speaker system as in claim 6 wherein the first and second equalization networks each includes a frequency divider for dividing the audio input signal range applied to it into high and low frequency portions, first and second dc converters for generating first and second dc control signals as a function of the magnitude of the high and low frequency portions, respectively, an equalizer for receiving the appropriate audio input signal range, a first frequency shaper for modifying the response of the equalizer as a function of the first dc control signals and a second frequency shaper for modifying the response of the equalizer as a function of the second dc control signal.

FIG. 1

**FIG. 2**

POWER SUPPLY *37*

*21*

INPUT

PRE-AMPLIFIER *20*

FREQUENCY DIVIDER *22*

H.F.

DC CONVERTER TIME CONSTANT NETWORK *24*

ACTIVE VOLTAGE CONTROL HIGH FREQUENCY SHAPER *28*

L.F.

DC CONVERTER TIME CONSTANT NETWORK *26*

ACTIVE VOLTAGE CONTROL LOW FREQUENCY SHAPER *30*

CONSTANT VELOCITY EQUALIZER *32*

POWER AMPLIFIER *36*

*12*

**FIG. 4**

INPUT

PRE AMPLIFIER *42*

ELECTRONIC CROSSOVER *44*

H.F.

C.V.C. *46*

POWER AMPLIFIER *50*

*52*

L.F.

C.V.C. *48*

POWER AMPLIFIER *54*

*56*

2/3

0122663

Fig.3